# EUROPÄISCHE PATENTSCHRIFT

(11) **EP 2 206 417 B1**
(45) Veröffentlichungstag und Bekanntmachung des Hinweises auf die Patenterteilung: **14.09.2011**
(21) Anmeldenummer: 08774005.6
(22) Anmeldetag: 17.07.2008
(51) Int. Cl.: H05H 1/24

(54) **VERFAHREN UND VORRICHTUNG ZUR BEHANDLUNG ODER BESCHICHTUNG VON OBERFLACHEN**
METHOD AND DEVICE FOR TREATMENT OR COATING OF SURFACES
PROCEDE ET DISPOSITIF POUR TRAITER OU REVÊTIR DES SURFACES

(30) Priorität: 11.09.2007 DE 102007043291
(43) Veröffentlichungstag der Anmeldung: 14.07.2010
(73) Patentinhaber: Maschinenfabrik Reinhausen GmbH, 93059 Regensburg (DE)
(72) Erfinder: BISGES, Michael, 93161 Sinzing (DE)
(86) Internationale Anmeldenummer: PCT/EP2008/005821
(87) Internationale Veröffentlichungsnummer: WO 2009/033522

(56) Entgegenhaltungen:
- WO-A-2005/125286
- GB-A- 943 793
- US-A- 4 540 121
- US-A1- 2007 065 582

## Beschreibung

Die Erfindung betrifft ein Verfahren zur Behandlung oder Beschichtung von Oberflächen mittels eines Plasma-Jets. Die Erfindung betrifft weiterhin eine zur Durchführung des Verfahrens geeignete Vorrichtung.

Als Plasma-Jet werden im Stand der Technik Plasmaströmungen bezeichnet, die eine Jet- oder Strahlform aufweisen, aus der diese Plasmaströmung erzeugenden Vorrichtung heraus extrahiert sind und sich bis zur Oberfläche eines in gewissem Abstand von der Vorrichtung angeordneten Substrates bzw. Werkstückes erstrecken. Die Erzeugung des eigentlichen Plasmas in Jet-Form kann prinzipiell auf zweierlei Weise erfolgen: Entweder durch eine dielektrisch behinderte Entladung oder eine Bogenentladung.

Eine Vorrichtung zur Erzeugung eines Plasma-Jets, die mit einer dielektrisch behinderten Entladung, auch als Atmosphärendruck-Glimmentladung bezeichnet, arbeitet, ist aus der WO 2005/125286 A2 bekannt. Bei dieser Vorrichtung sind zwei Elektroden durch ein als dielektrische Barriere wirkendes Isolierrohr voneinander getrennt. Weiterhin wird durch die Vorrichtung hindurch ein Trägergas geführt. Auf diese Weise entsteht beim Anlegen einer Wechselspannung zwischen den Elektroden am freien Ende der Vorrichtung ein Plasmastrahl.

Eine Vorrichtung zur Erzeugung eines Plasma-Jets, die mit einer direkten Bogenentladung arbeitet, ist aus der EP 0 761 415 bekannt. Bei dieser Vorrichtung bildet sich zwischen zwei sich direkt gegenüberstehenden Elektroden ein direkter Lichtbogen aus, wobei ebenfalls ein Trägergas durch die Vorrichtung geführt wird.

Zur Behandlung oder Beschichtung von Oberflächen wird bei allen bekannten Vorrichtungen versucht, den erzeugten Plasmastrahl und ein zusätzliches Prozessgas, das zur Behandlung bzw. Beschichlung dient, unmittelbar vor oder erst nach dem Austreten des Plasmastrahls aus dem Plasmakopf zu vermischen, um Ablagerungen an den Begrenzungswänden bzw. an der Austrittsdüse der Vorrichtung selbst zu vermeiden oder wenigstens zu verringern. Nachteilig ist dabei stets die parallele Strömungsrichtung von Prozessgas und Plasmastrahl und die daraus resultierende schlechte Aktivierung. Zusätzlich wird durch den aus dem Düsenkopf austretenden Plasmastrahl die Umgebungsluft radikalisiert, wodurch es zu Abbruchprozessen im eigentlich aktivierten Prozessgas kommt.

Bei der in der bereits genannten WO 2005/125286 beschriebenen Vorrichtung, die mit einer dielektrisch behinderten Entladung arbeitet, wird zusätzlich zum plasmabildenden Trägergas ein Prozessgas durch ein innerhalb der Innenelektrode liegendes Innenrohr zugeführt. Die Vermischung von Plasma und Prozessgas erfolgt dabei erst nach dem Verlassen der Austrittsdüse der Vorrichtung im räumlichen Bereich zwischen Substrat und Plasmakopf. Nachteilig ist hierbei die bereits angesprochene unzureichende Aktivierung des Prozessgases, da, wie erläutert, Plasmastrahl und Prozessgas im Wesentlichen parallel auf das Substrat strömen und somit eine Aktivierung des Prozessgases nur unzureichend erfolgt.

In der WO 99/20809 wird eine weitere Vorrichtung beschrieben, die einen Plasma-Jet erzeugt, wobei hier die Zuführung des Prozessgases unmittelbar vor der Austrittsdüse erfolgt. Dadurch vermeidet man die chemischen Reaktionen im Bereich der Elektroden. Das Berührungsvolumen zwischen Plasma-Jet und Prozessgas ist bei dieser Vorrichtung konstruktiv auf ein Minimum beschränkt, um Ablagerungen des bereits aktivierten Prozessgases im Plasmakopf der Vorrichtung zu vermeiden.

In der GB 943793 wird eine weitere Vorrichtung beschrieben, die einen Plasma-Jet erzeugt, wobei eine separate Reaktionskammer vorgesehen ist, die eine Eintrittsöffnung für den Plasma-Jet sowie eine Einlassöffnung und eine Auslassöffnung für das Trägergas aufweist.

Bei den bekannten Vorrichtungen ist es weiterhin nachteilig, dass der Plasmastrahl, der nur unvollständig mit dem Prozessgas reagiert, zum wesentlichen Teil ungehindert auf die zu behandelnde oder beschichtende Oberfläche trifft. Durch die Sekundärstrahlung des Plasmas im UV-Bereich und die direkte physische Berührung des Plasmas mit der Oberfläche kommt es dort zu unverwünschten chemischen und physikalischen Prozessen. So kann es etwa zur Aufspaltung von Polymeren sowie zur unerwünschten Einlagerung von Sauerstoff in die Oberfläche kommen.

Aufgabe der Erfindung ist es, ein Verfahren anzugeben, bei dem zur Behandlung oder Beschichtung von Oberflächen ein Plasmastrahl in Form eines Plasma-Jets und mindestens ein Prozessgas möglichst vollständig durchmischt werden und ein möglichst vollständiger Energietransfer vom Plasma hin zum Prozessgas erfolgen kann, so dass ein optimal aktiviertes Gemisch aus Träger- und Prozessgas auf die entsprechende Oberfläche trifft. Dabei soll kein direkter Kontakt zwischen dem Plasma-Jet und der Oberfläche möglich sein. Weiterhin ist es Aufgabe der Erfindung, eine möglichst einfache Vorrichtung anzugeben, die für die Durchführung eines solchen erfindungsgemäßen Verfahrens geeignet ist.

Die Aufgabe wird ein Verfahren mit den Merkmalen des ersten Patentanspruches sowie eine Vorrichtung mit den Merkmalen des nebengeordneten vierten Patentanspruches gelöst. Die Unteransprüche betreffen jeweils besonders vorteilhafte Weiterbildungen der Erfindung, bezogen auf das Verfahren bzw. die Vorrichtung.

Die Erfindung geht von der allgemeinen erfinderischen Idee aus, eine erzeugte Plasmaströmung in Form eines Plasma-Jets und mindestens ein Prozessgas unter Ausschluss der Umgebungsluft in einem separaten räumlichen Bereich miteinander zu durchmischen. Dazu wird das Prozessgas in eine der Austrittsdüse eines bekannten Plasma-Jets nachfolgend angeordnete Reaktionskammer geführt, wobei in dieser Reaktionskammer durch eine geeignete Strahlführung und entsprechende Strömungsgeometrie eine möglichst vollständige Durchmischung von Plasmastrahl einerseits und Prozessgas andererseits erfolgt. Erst danach wird das auf diese Weise aktivierte Prozessgas über eine Austrittsdüse in direkten Kontakt mit der Oberfläche des Werkstückes gebracht, um diese Oberfläche zu konditionieren oder auf ihr Schichten abzuschneiden.

Gemäß einer besonders vorteilhaften Ausführungsform der Erfindung sind die Strömungsrichtungen des Plasmastrahls einerseits sowie des Prozessgases andererseits beim Eintritt in die Reaktionskammer senkrecht oder nahezu senkrecht zueinander. Hierdurch kommt es zu einer besonders intensiven Vermischung der beiden Medien.

Nach einer weiteren vorteilhaften Ausführungsform der Erfindung wird der Plasmastrahl im Wesentlichen parallel zur Oberfläche des zu behandelnden oder zu beschichtenden Werkstücks in die Reaktionskammer geführt und das Prozessgas im wesentlich senkrecht zur Oberfläche zugeführt. Bei dieser Ausführungsform werden beide Medien optimal miteinander vermischt, ohne dass der Plasmastrahl selbst durch die Reaktionskammer hindurch laufen könnte. Dies ermöglicht eine kleine Baugröße der Reaktionskammer.

Nach einer weiteren vorteilhaften Ausführungsform der Erfindung ist die Reaktionskammer zusätzlich mit einem Kühl-/Heizsystem versehen, um die bei der Vermischung von Plasmastrahl und Prozessgas ablaufenden chemischen und physikalischen Prozesse kontrollieren zu können. Es ist beispielsweise möglich, durch Temperierkanäle in den Begrenzungswänden der Reaktionskammer ein flüssiges, temperiertes Medium zu leiten. Eine Temperierung kann ebenso auch mit einem elektrischen Heizsystem erfolgen.

Schließlich ist es gemäß einer weiteren vorteilhaften Weiterbildung der Erfindung auch möglich, mehrere Plasma-Jets an der Reaktionskammer anzuordnen, derart, dass eine Vermischung mehrerer Plasmastrahlen mit dem Prozessgas möglich ist.

Es ist auch möglich, nacheinander verschiedene Prozessgase zuzuführen und dazu mehrere Reaktionskammern oder auch eine zwei- oder mehrstufig ausgebildete kombinierte Reaktionskammer vorzusehen.

Alle Ausführungsformen der Erfindung weisen eine Reihe von Vorteilen gegenüber dem Stand der Technik auf:
Zunächst einmal wird die Plasmaenergie fast vollständig in die Aktivierung des Prozessgases umgesetzt weiterhin werden durch Ausschluss von Luftsauerstoff in der Reaktionskammer unerwünschte Nebenreaktionen zwischen Umgebungsluft, Plasma und Prozessgas vermieden. Nur das aktivierte Prozessgas und nicht der Plasmastrahl selbst werden mit der Oberfläche des zu behandelnden oder zu beschichtenden Werkstückes in Kontakt gebracht.

Durch die Vermeidung dieses direkten Kontaktes zwischen Plasma und Werkstückoberfläche wird der schädigende Einfluss der sekundären UV-Strahlung vermieden. Durch die Vermeidung dieses direkten Kontaktes werden weiterhin andere Effekte, die das Plasma auf der Werkstückoberfläche hervorrufen könnte, wie eine Änderung der Oberflächenspannung, ein Einbringen von reaktiven Sauerstoffgruppen in diese Oberfläche usw., vermieden.

Die Erfindung soll nachfolgend an Hand von Zeichnungen beispielhaft noch näher erläutert werden.

Es zeigen:
- Fig. 1: einen schematischen Ablaufplan eines erfindungsgemäßen Verfahrens zur Behandlung oder Beschichtung von Oberflächen
- Fig. 2: eine erste erfindungsgemäße Vorrichtung zur Behandlung oder Beschichtung von Oberflächen
- Fig. 3: eine zweite derartige Vorrichtung
- Fig. 4: eine dritte derartige Vorrichtung
- Fig. 5: eine vierte derartige Vorrichtung
- Fig. 6: eine fünfte derartige Vorrichtung.

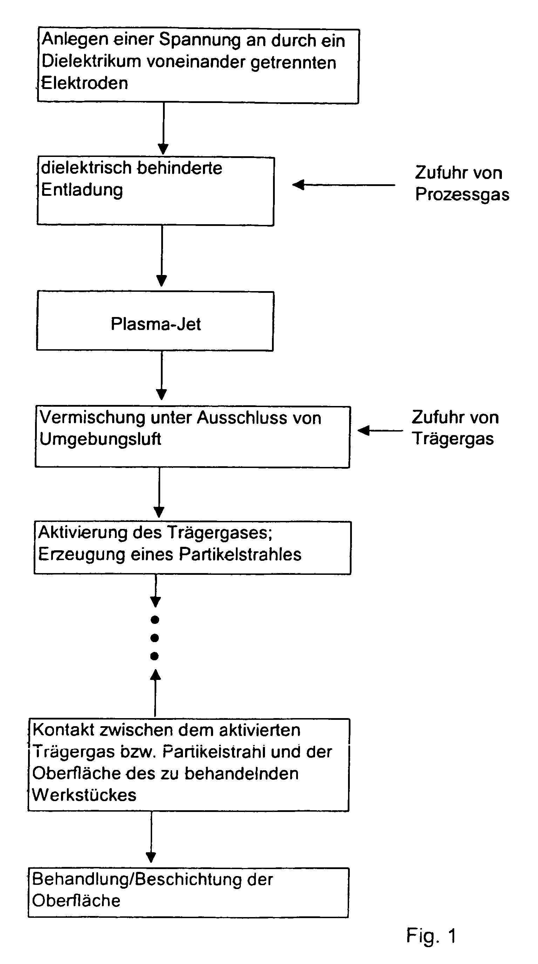

Zunächst soll das in Figur 1 schematisch dargestellte Verfahren näher erläutert werden. Bei diesem Beispiel wird von der Erzeugung eines Plasma-Jets mittels dielektrisch behinderter Entladung ausgegangen. Dazu wird an die durch ein Dielektrikum voneinander getrennten Elektroden eine Spannung angelegt. Bei der bereits eingangs erläuterten Vorrichtung gemäß der WO 2005/125286 ist dies ein Isolierrohr, wobei, konzentrisch aufgebaut, innerhalb und außerhalb dieses Isolierrohres die Elektroden vorgesehen sind. Dabei entsteht eine Glimmentladung; durch Zufuhr eines Prozessgases, das die Vorrichtung durchströmt, entsteht ein Plasma-Jet, der aus der Vorrichtung austritt.

Dieser Plasma-Jet wird nachfolgend unter Ausschluss der Umgebungsluft mit einem zugeführten separaten Trägergas vermischt. Das Trägergas dient zur Behandlung der Oberfläche des Werkstückes oder enthält die Partikel zur späteren Beschichtung dieser Oberfläche des Werkstückes. Diese Vermischung unter Ausschluss der Umgebungsluft vollzieht sich in einer Reaktionszone außerhalb der den Plasma-Jet erzeugenden Vorrichtung, in der ein gegenüber der Umgebung erzeugter Druck herrschen kann. In dieser Reaktionszone erfolgt eine intensive Vermischung des Plasmastrahls einerseits und des im Trägergas enthaltenden Gas- und Partikelstroms andererseits. In diesem Bereich wird damit der größte Teil der im Plasma enthaltenen Energie an den Gas- und/oder Partikelstrom übertragen Dazu ist es sinnvoll, durch geeignete technische Mittel in der Reaktionszone einen gegenüber der Umgebung erhöhten Druck zu erzeugen, wodurch das Eintreten von Umgebungsluft in diesem Bereich vermieden wird.

Insgesamt wird, wie erläutert, in diesem Reaktionsbereich das zugeführte Trägergas aktiviert bzw. ein Partikelstrahl erzeugt.

Es ist auch möglich, die beiden letzten dargestellten Verfahrensschritte zu wiederholen, d. h. nacheinander mehrere Aktivierungszonen vorzusehen, bei denen entweder jeweils dasselbe Trägergas oder auch unterschiedliche Trägergase zugeführt werden können. Ein solches Verfahren mit mehreren Aktivierungszonen ist besonders geeignet, um entweder eine besonders intensive Aktivierung des Trägergases zu erreichen oder ein Gemisch mit mehreren aktivierten Gasen zu erzeugen.

Nachfolgend wird das gemäß den bisher erläuterten Verfahrensschritten aktivierte Trägergas bzw. der Partikelstrahl in Kontakt mit der Oberfläche des zu behandelnden Werkstückes gebracht und die Oberfläche auf diese Weise behandelt bzw. beschichtet.

Charakteristisch für das erläuterte erfindungsgemäße Verfahren ist, dass der Plasmastrahl im separaten Reaktionsbereich bzw. in den separaten Reaktionsbereichen die Plasmaenergie zum allergrößten Teil an den Gas- und/oder Partikelstrom überträgt und, dies ist besonders wichtig, dass der Plasmastrahl selbst nicht oder nur noch zu einem ganz geringen Teil mit der Oberfläche in direkten Kontakt kommt.

Weiterhin ist beim erfindungsgemäßen Verfahren typisch, dass dadurch, dass in der Reaktionszone die Umgebungsluft ausgeschlossen wird, die bereits eingangs erwähnten unerwünschten Nebenreaktionen zwischen Umgebungsluft, Plasma und Prozessgas vermieden werden.

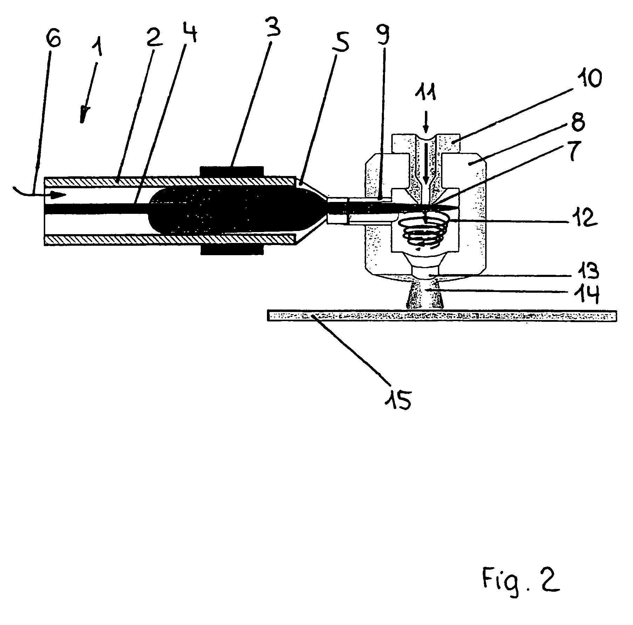

Figur 2 zeigt eine erste erfindungsgemäße Vorrichtung. Die Vorrichtung 1 zur Erzeugung eines Plasma-Jets weist eine dielektrische Barriere 2, hier ein Isolierrohr, auf. Konzentrisch darum ist eine äußere Elektrode 3 angeordnet, im Zentrum verläuft eine innere Elektrode 4. An ihrem freien Ende wird die Vorrichtung 1 von einem Plasmakopf 5 abgeschlossen. In der mit dem Pfeil angedeuteten Richtung wird ein Prozessgas 6 zugeführt; in der Folge entsteht ein Plasma-Jet 7, der durch eine Öffnung im Plasmakopf 5 nach außen tritt. In Verbindung mit der Vorrichtung 1 steht eine geschlossene Reaktionskammer 8, die eine Einlassöffnung 9 für den Plasma-Jet 7 aufweist. Besonders vorteilhaft ist diese Einlassöffnung 9 gegen die Öffnung des Plasmakopfes 5 abgedichtet, um den Eintritt von Umgebungsluft zu vermeiden. Die Reaktionskammer 8 besitzt eine weitere Einlassöffnung 10, durch die ein Trägergas 11 in einen Innenraum 12 der Reaktionskammer 8 geblasen wird. Weiterhin weist die Reaktionskammer 8 eine Austrittsöffnung 13 auf. Durch die Einlassöffnung 9 reicht der Plasma-Jet 7 bis ins Innere des Innenraumes 12. Dort erfolgt ein intensives Vermischen von Plasma-Jet 7 und Trägergas 11. Das auf diese Weise aktivierte Trägergas 14 tritt durch die Austrittsöffnung 13 aus der Reaktionskammer 8, trifft auf ein Werkstück 15 und behandelt oder beschichtet dessen Oberfläche. Bei dieser Ausführung ist eine Reaktionskammer 8 mit Innenmischung vorgesehen, dabei erfolgt der Eintritt des Plasma-Jets 7 senkrecht zum Strahl des aktivierten Trägergases 14, was zu einer besonders intensiven Durchmischung und intensivem Energieaustausch führt.

Besonders vorteilhaft ist es, wenn Eintrittsöffnung 9 und Austrittsöffnung 13 an gegenüberliegenden Seiten der Reaktionskammer 8 liegen, so dass durch eine seitlich angeordnete Einlassöffnung 10 für das einzublasende Trägergas 11 eine Verwirbelung und/oder Ablenkung des Plasma-Jets 7 von der Geraden erfolgt.

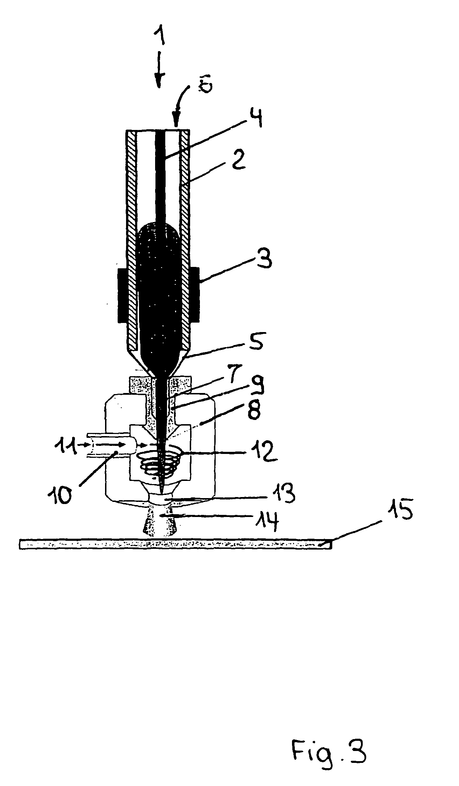

Figur 3 zeigt eine weitere erfindungsgemäße Vorrichtung, bei der abweichend der Plasma-Jet 7 in gleicher Richtung in die Reaktionskammer 8 geführt wird, in der das aktive Trägergas 14 diese verlässt.

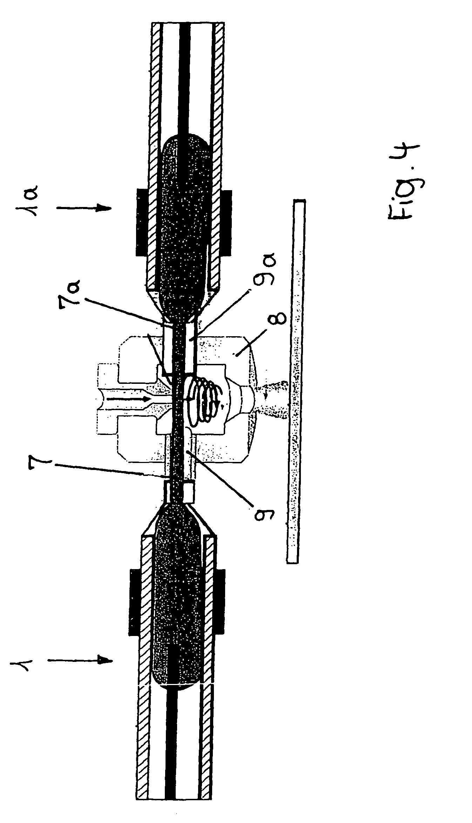

Figur 4 zeigt eine weitere Vorrichtung, bei der zwei identische Vorrichtungen 1, 1a zur Erzeugung jeweils eines Plasma-Jets 7, 7a seitlich vorgesehen sind. Hierbei weist die Reaktionskammer 8 zwei Einlassöffnungen 9, 9a auf durch die jeweils einer der beiden erzeugten Plasma-Jets 7, 7a in den Innenraum 12 geführt ist.

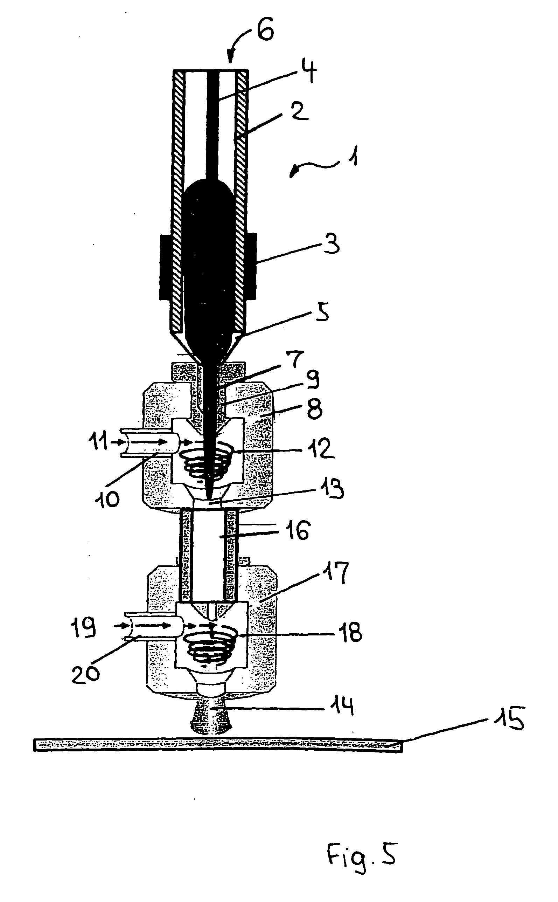

Figur 5 zeigt eine weitere Vorrichtung, bei der anschließend an die Austrittsöffnung 13 der Reaktionskammer 8, verbunden durch ein Verbindungsstück 16, eine weitere Reaktionskammer 17 vorgesehen ist. In den Innenraum 18 dieser weiteren Reaktionskammer 17 ist ein weiteres Trägergas 19 durch eine weitere Eintrittsöffnung 20 einblasbar. Beide Trägergase 11 und 19 können identisch oder auch verschieden sein. Es ist z. B. möglich, als erstes Trägergas 11 einen Plasmainitiator und als zweites Trägergas 19 ein Aerosol, z. B. mit Nanopartikeln und/oder Bindemitteln, vorzusehen. In jeder der beiden Reaktionskammern 8, 17 erfolgt ein Vermischen des jeweils zugeführten Mediums mit dem jeweils zugeführten Trägergas.

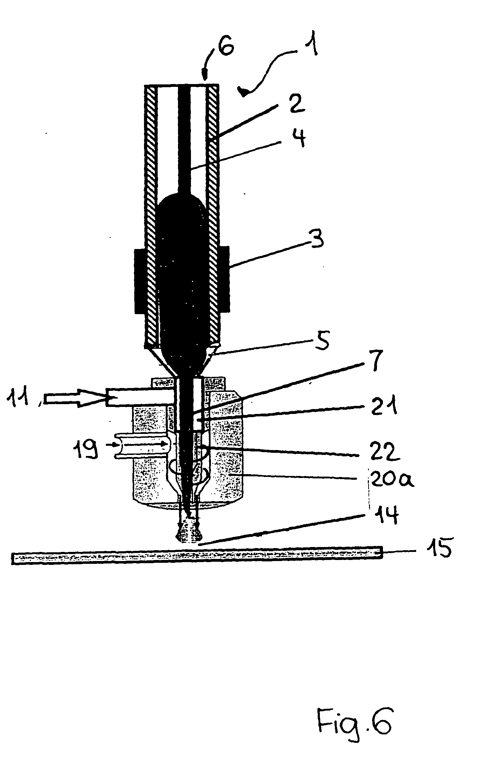

Figur 6 zeigt eine weitere Vorrichtung, bei der ebenso wie in der gerade erläuterten Figur 5 eine zweistufige Reaktionskammer vorgesehen ist. Während beim in Figur 5 dargestellten Ausführungsbeispiel jedoch zwei identische Reaktionskammern 8, 17 kaskadenartig hintereinander geschaltet sind - wobei natürlich diese Kaskadenanordnung auch noch mehr als zwei Reaktionskammern umfassen kann - ist bei dem jetzt zu erläuternden Ausführungsbeispiel eine kombinierte Reaktionskammer 20a vorgesehen, die einen ersten Innenraum 21 und einen zweiten Innenraum 22 besitzt. Im ersten Innenraum 21 erfolgt eine Durchmischung des zugeführten Plasma-Jets 7 mit dem ersten Trägergas 11. Im zweiten Innenraum 22 erfolgt eine weitere Durchmischung des den ersten Innenraum 21 verlassenden aktivierten Mediums mit dem weiteren Trägergas 19.

Es ist in vorteilhafter Weiterbildung der Erfindung möglich, die Reaktionskammer 8 bzw. die Reaktionskammern 8, 17 mittels elektrischer oder auch Flüssigkeitstemperierung zu beheizen oder zu kühlen. Durch Aufheizung der entsprechenden Reaktionskammer kann eine Kondensation des aktivierten Mediums vermieden werden. Weiterhin ist es auf diese Weise möglich, das ein in die jeweilige Reaktionskammer eingespeistes flüssiges Medium statt des Trägergases dort durch die Temperierung verdampft wird.

Durch entsprechende Gestaltung der der zu behandelnden oder zu beschichtenden Werkstückoberfläche zugewandten Austrittsöffnung der Vorrichtung in Düsenform ist es möglich, einen linearen Strahl des aktivierten Mediums auf die Werkstückoberfläche zu erzeugen; ebenso ist etwa ein fächerförmiger oder auch ein kegelförmiger Strahl durch eine geeignete Düsenausbildung im Rahmen der Erfindung möglich.

Weiterhin ist es möglich, alle oder auch einzeln Eintritts- und/oder Austrittsöffnungen der Vorrichtung über ein Düsensystem, eine verstellbare Blende oder andere, an sich bekannte Regelmöglichkeiten zu verstellen oder zu verschließen. Auf diese Weise ist durch eine einfache Regelung des Querschnittes der jeweiligen Eintritts- und/oder Austrittsöffnung die Verweilzeit der Plasma-, Gas- und/oder Partikelströme in der jeweiligen Reaktionskammer einstell- und veränderbar.

Die erfindungsgemäße Vorrichtung lässt sich besonders vorteilhaft aus zwei separaten Baugruppen zusammensetzen. Als erste Baugruppe zur Erzeugung eines Plasma-Jets ist vorteilhaft das von der Anmelderin hergestellte und vertriebene Gerät plasmabrush® verwendbar, bei dem der Plasma-Jet mittels einer dielektrisch behinderten Barrierenentladung erzeugt wird. Eine zweite Baugruppe kann dann eine oder auch mehrere Reaktionskammern mit den jeweiligen Einlass- und Auslassöffnungen umfassen. Besonders vorteilhaft ist dabei eine Einlassöffnung 9 so angepasst, dass sie mit dem Plasmakopf 5 des Gerätes plasmabrush® direkt baukastenartig korrespondiert, so dass dieser Plasmakopf 5 direkt und abdichtend auf die Einlassöffnung 9 aufgesetzt werden kann.

## Patentansprüche

1. Verfahren zur Behandlung oder Beschichtung von Oberflächen mittels eines Plasma-Jets, wobei durch eine Entladung zwischen zwei Elektroden, an die eine Spannung angelegt wird, und unter Zufuhr eines Prozessgases in einem Plasmakopf ein Plasma-Jet erzeugt wird, der den Plasmakopf durch eine Öffnung verlässt und in einen separaten Reaktionsraum strömt,
wobei im Reaktionsraum unter Ausschluss der den erzeugten Plasma-Jet umgebenden Atmosphäre ein Trägergas zugeführt und mit dem Plasma-Jet durchmischt wird und wobei in der Folge das Trägergas aktiviert und/oder ein Partikelstrahl erzeugt wird, **dadurch gekennzeichnet,**
**dass** das Trägergas senkrecht zur Strömungsrichtung des Plasma-Jets in den Reaktionsraum mittels einer Einlassöffnung einströmt,
**dass** das aktivierte Trägergas bzw. der Partikelstrahl nach einer Verwirbelung und Durchmischung mit dem Plasma-Jet wiederum senkrecht zur Strömungsrichtung des Plasma-Jets aus dem Reaktionsraum mittels einer Auslassöffnung ausströmt und dass nur das aus der Auslassöffnung ausströmende aktivierte Trägergas bzw. der Partikelstrahl auf die Oberfläche des zu behandelnden oder zu beschichtenden Werkstückes gerichtet werden, während der Plasma-Jet selbst in dem Reaktionsraum eingeschlossen bleibt.

2. Verfahren nach Anspruch 1,
**dadurch gekennzeichnet,**
**dass** der Plasma-Jet durch eine dielektrisch behinderte Barrierenentladung erzeugt wind.

3. Verfahren nach Anspruch 1 oder 2,
**dadurch gekennzeichnet,**
**dass** mehrere unabhängig voneinander erzeugte Plasma-Jets gleichzeitig oder nacheinander mit dem Trägergas durchmischt werden.

4. Verfahren nach Anspruch 1 oder 2,
**dadurch gekennzeichnet,**
**dass** der oder die Plasma-Jets nacheinander mehrmals mit demselben Trägergas durchmischt wird bzw. werden.

5. Verfahren nach Anspruch 1 oder 2,
**dadurch gekennzeichnet,**
**dass** der oder die Plasma-Jets nacheinander mit unterschiedlichen Trägergasen durchmischt wird oder werden.

6. Vorrichtung zur Behandlung oder Beschichtung von Oberflächen mittels eines Plasma-Jets (7), wobei eine Einrichtung in einem Plasmakopf (5) zur Erzeugung eines Plasma-Jets (7) unter Zufuhr eines Prozessgases (6) vorgesehen ist, derart, dass der Plasma-Jet (7) aus einer Öffnung der Einrichtung ausströmt,
wobei weiterhin eine separate Reaktionskammer (8) vorgesehen ist, die eine Eintrittsöffnung (9) für den Plasma-Jet (7) sowie eine Einlassöffnung (10) und eine Auslassöffnung (13) für das Trägergas (11) aufweist,
**dadurch gekennzeichnet,**
**dass** die Einlassöffnung (9) für den Plasma-Jet (7) senkrecht zu einer von Einlassöffnung (10) für das Trägergas (11) und gegenüberliegender Auslassöffnung (13) für das Trägergas (11) gebildeten Linie angeordnet ist
und **dass** die Reaktionskammer (8) auf der der Einlassöffnung (9) für den Plasma-Jet (7) gegenüberliegenden Seite geschlossen ist.

7. Vorrichtung nach Anspruch 6,
**dadurch gekennzeichnet,**
**dass** mehrere Reaktionskammern (8, 17) kaskadenartig hintereinander angeordnet sind, derart, dass jeweils die Austrittsöffnung (13) der ersten Reaktionskammer (8) mit einer Eintrittsöffnung
der nachfolgenden weiteren Reaktionskammer (17) in Verbindung steht.

8. Vorrichtung nach einem der Ansprüche 6 oder 7,
**dadurch gekennzeichnet,**
**dass** die mindestens eine Reaktionskammer (8, 17, 20a) gezielt temperierbar, d. h. heiz- oder kühlbar ist.

9. Vorrichtung nach einem der Ansprüche 6 bis 8,
**dadurch gekennzeichnet,**
**dass** mindestens eine Eintritts- und/oder Austrittsöffnung (9, 10, 13; 17, 20) regelbar oder verschließbar ist.

## Claims

1. A method of treating or finishing surfaces using a plasma-jet, where this plasma-jet is formed by an electrical discharged between two electrodes to which a voltage is applied and a process gas is fed into the plasma head through an opening creating a plasma-jet where this leaves the head through an opening and enters a separate reaction chamber,
and here a carrier gas is injected into the atmosphere created by the plasma-jet and is mixed with the plasma-jet, where this activates the carrier gas and / or creates a particle stream, **characterised in that** the carrier gas is injected perpendicularly to the flow direction of the plasma-jet in the reaction chamber through an inlet opening,
where the activated carrier gas or particle stream is mixed with and swirled by the plasma-jet and then leaves again perpendicular to the plasma-jet's flow direction through an outlet, where only the activated carrier gas or particle stream is directed onto the workpiece surface to be treated or coated, whereas the plasma-jet itself is contained within the reaction chamber.

2. Process meeting requirement 1, **characterised in that** the plasma-jet is created by a dielectric barrier discharge.

3. Process meeting requirement 1 or 2, **characterised in that** several independently generated plasma-jets are simultaneously or sequentially mixed with the carrier gas.

4. Process meeting requirement 1 or 2, **characterised in that** the plasma-jet(s) is / are successively mixed with the same carrier gas several times.

5. Process meeting requirement 1 or 2, **characterised in that** the plasma-jet(s) is / are successively mixed with different carrier gases.

6. Device for treating or coating surfaces using a plasma-jet (7), whereby the plasma-jet (7) is generated in a part of a plasma head (5) while supplying a process gas (5), the plasma-jet (7) leaves an opening in the part and enters a separate reaction chamber (8), this has an inlet opening (9) for the plasma-jet (7) and an inlet opening (10) and outlet opening (13) for the carrier gas (11), it is **characterised in that** the inlet opening (9) for the plasma-jet (7) is perpendicular to a line connecting the inlet opening (10) for the carrier gas (11) and opposing outlet opening (13) for the carrier gas (11) and that the reaction chamber is closed opposite the inlet opening (9) for the plasma-jet (7).

7. A device meeting requirement 6, **characterised in that** multiple reaction chambers (8, 17) are arranged in a cascade behind one another such that the outlet opening (13) of the first reaction chamber (8) is connected with the inlet opening of the following reaction chamber (17).

8. A device meeting requirement 6 or 7, **characterised in that** at least one of the reaction chambers (8, 17, 20a) has a controllable temperature, i.e. it can be heated or cooled.

9. A device meeting one of the requirements 6 to 8, **characterised in that** at least one inlet and / or outlet opening (9, 10, 13, 17, and 20) is controllable or can be closed.

## Revendications

1. Procédé pour traiter ou revêtir les surfaces à l'aide d'un jet plasma, en sachant que la décharge de deux électrodes mises sous tension et l'apport d'un gaz de procédé dans une tête plasma permet de générer un jet plasma qui sort de la tête plasma par un orifice et est amené dans une chambre à réaction séparée,
en sachant que dans la chambre à réaction, l'atmosphère environnant le jet plasma a été exclue et qu'un gaz support est ajouté puis mélangé au jet plasma entraînant l'activation et/ou la génération d'un jet de particules, et **caractérisé par le fait que** le gaz support s'écoule verticalement dans la chambre à réaction par rapport au sens d'écoulement du jet plasma au travers d'un orifice d'entrée,
que le gaz support ou le jet de particules activé est purgé verticalement par rapport au jet plasma vers un orifice de purge après son mélange et son tourbillonnement avec le jet plasma,
et que seul le gaz support / le jet de particules activé qui a été purgé par l'orifice de purge, est amené à la surface de la pièce à traiter ou à revêtir tandis que le jet plasma quant à lui, reste enfermé dans la chambre à réaction.

2. Procédé suivant la revendication 1,
**caractérisé par le fait**
**que** le jet plasma est généré par une décharge barrée diélectriquement.

3. Procédé suivant la revendication 1 ou 2
**caractérisé par le fait**
**que** plusieurs jets plasma, qui sont respectivement indépendants, sont mélangés simultanément ou successivement avec le gaz support

4. Procédé suivant la revendication 1 ou 2
**caractérisé par le fait**
**que** le ou les jet(s) plasma sont ou seront mélangés plusieurs fois avec le même gaz support

5. Procédé suivant la revendication 1 ou 2
**caractérisé par le fait**
**que** le ou les jet(s) plasma sont ou seront mélangés plusieurs fois avec des gaz support différents

6. Procédé pour traiter ou revêtir les surfaces à l'aide d'un jet plasma (7),
en sachant qu'un dispositif dans la tête plasma (5) a été prévu pour générer le jet plasma (7) par l'ajout d'un gaz de procédé (6) de telle manière à ce que le jet plasma (7) s'écoule par un orifice de purge du dispositif,
en sachant qu'une chambre à réaction séparée a été prévue (8) qui est dotée à la fois d'un orifice d'entrée (9) pour le jet plasma (7), d'un orifice d'admission (10) et d'un orifice de purge (13) pour le gaz support (11),
**caractérisé par le fait,**
**que** l'orifice d'entrée (9) pour le jet plasma (7) est placé verticalement et sur une même ligne avec l'orifice d'admission (10) pour le gaz support (11), et à l'opposé de l'orifice de purge (13) du gaz support (11),
et **que** la chambre à réaction (8) est raccordée au côté opposé d'où se trouve l'orifice d'entrée (9) pour le jet plasma (7).

7. Procédé suivant la revendication 6,
**caractérisé par le fait**
**que** plusieurs chambres à réaction (8, 17) sont placées les unes derrière les autres en cascade, de manière à ce que respectivement, l'orifice de purge (13) de la première chambre à réaction (8) soit raccordé avec l'orifice d'entrée de la chambre à réaction suivante (17).

8. Procédé suivant la revendication 6 ou 7,
**caractérisé par le fait**
**qu'**au moins une des chambres à réaction (8, 17, 20a) peut être tempérée de manière précise, c'est à dire chauffée ou refroidie.

9. Procédé suivant la revendication 6 à 8
**caractérisé par le fait**
**qu'**au moins un des orifices d'entrée / de purge (9, 10, 13, 17, 20) est réglable ou verrouillable.
